# EUROPÄISCHE PATENTSCHRIFT

(11) **EP 2 807 907 B1**
(45) Veröffentlichungstag und Bekanntmachung des Hinweises auf die Patenterteilung: **04.11.2015**
(21) Anmeldenummer: 12810068.2
(22) Anmeldetag: 28.11.2012
(51) Int. Cl.: H05K 5/00

(54) **VERFAHREN ZUM HERSTELLEN EINES STEUERGERÄTGEHÄUSES SOWIE EIN NACH DIESEM VERFAHREN HERGESTELLTES STEUERGERÄTGEHÄUSE**
METHOD FOR PRODUCING A CONTROL UNIT HOUSING AND CONTROL UNIT HOUSING PRODUCED ACCORDING TO SAID METHOD
PROCÉDÉ DE FABRICATION D'UN BOÎTIER D'APPAREIL DE COMMANDE ET BOÎTIER D'APPAREIL DE COMMANDE FABRIQUÉ SELON CE PROCÉDÉ

(30) Priorität: 26.01.2012 DE 102012001478
(43) Veröffentlichungstag der Anmeldung: 03.12.2014
(73) Patentinhaber: WABCO GmbH, 30453 Hannover (DE)
(72) Erfinder: BOLIK, Thomas, 30559 Hannover (DE); BRAMMER, Christian, 29303 Bergen (DE); PIASECKI, Sylwester, P-58-105 Swidnica (PL); SZCZERBA, Dominik, PL-55-040 Domaslaw (PL)
(74) Vertreter: Lauerwald, Jörg
(86) Internationale Anmeldenummer: PCT/EP2012/004892
(87) Internationale Veröffentlichungsnummer: WO 2013/110301

(56) Entgegenhaltungen:
- EP-A1- 1 895 823
- WO-A1-2009/010705
- DE-A1- 10 129 451

## Beschreibung

Die Erfindung betrifft ein Verfahren zum Herstellen eines Steuergerätgehäuses mit darin angeordneten Steckerpins, die jeweils ein in das Gehäuseinnere gerichtetes erstes Kontaktende für eine Press-fit-Verbindung mit einer in das Steuergerätgehäuse einzusetzenden Leiterplatte sowie ein aus dem Steuergerätgehäuse nach außen gerichtetes zweites Kontaktende für den Anschluss eines elektrischen Steckverbinders oder dergleichen aufweisen, und sie betrifft ein nach diesem Verfahren hergestelltes Steuergerätgehäuse.

Derartige Steuergerätgehäuse finden insbesondere im modernen Fahrzeugbau Verwendung, wo sie beispielsweise Steuerungskomponenten der Fahrzeugsteuerung aufnehmen, die über Steckverbinder mit Sensoren und den zu steuernden Funktionselementen verbunden sind. Nach dem Einsetzen einer eine elektronische Schaltung aufnehmenden Leiterplatte in das Steuergerätgehäuse wird dieses mittels eines passenden Deckels und diesem zugeordnete Dichtungen mediendicht verschlossen, um die Steuerung vor ungünstigen Umweltbedingungen zu schützen. Bekannte Steuergerätgehäuse der eingangs genannten Art umfassen beispielsweise einen zweiseitig offenen Steckerrahmen mit darin ausgebildeten Materialvorsprüngen zur Aufnahme von Steckerpins. In den Materialvorsprüngen sind Durchgangsbohrungen oder dergleichen ausgebildet, in die gerade Steckerpins derart eingesetzt werden, dass beide Kontaktenden der Steckerpins aus den zugeordneten Durchgangsbohrungen herausragen. Dabei ist jeweils ein erstes, in das Gehäuseinnere gerichtetes Kontaktende für eine Press-fit-Verbindung mit einer in das Steuergerätgehäuse einzusetzenden Leiterplatte vorgesehen, während das andere, zweite Kontaktende aus dem nach der Montage der Leiterplatte verschlossenen Steuergerätgehäuse herausragt und für den Anschluss eines Steckverbinders vorgesehen ist.

Ein Nachteil der bekannten Steuergerätgehäuse wird darin gesehen, dass die bei der Montage der Leiterplatte mittels einer Press-fit-Verbindung auf die Steckerpins wirkende Montagekraft durch zugeordnete Untermatrizen, auf denen sich die Steckerpins mittels an diesen ausgebildeten Schultern abstützen, aufgenommen werden muss, was montagetechnisch verhältnismäßig aufwendig ist. Außerdem ist es wegen der beschriebenen Montagetechnik unabdingbar, dass das Steuergerätgehäuse zunächst als Steckerrahmen mit zwei Zugangsöffnungen ausgebildet ist, bei dem die der Zugangsöffnung zum Einsetzen der Leiterplatte gegenüberliegende Zugangsöffnung für die Anordnung der Untermatrize erforderlich ist. Um das Steuergerätgehäuse nach der Montage der Leiterplatte mediendicht zu verschließen, sind demnach zwei Deckel mit jeweils zugeordneter Dichtung erforderlich.

Vor diesem Hintergrund liegt der Erfindung die Aufgabe zugrunde, ein Verfahren zum Herstellen eines Steuergerätgehäuses sowie ein nach diesem Verfahren hergestelltes Steuergerätgehäuse vorzuschlagen, die einerseits eine vereinfachte Montage der Steckerpins im Steuergerätgehäuse sowie eine vereinfachte Press-fit-Verbindung der Leiterplatte mit den Steckerpins ermöglichen, und die eine zweite Zugangsöffnung und damit einen zweiten Deckel samt zugeordneter Dichtung überflüssig machen.

Die Lösung dieser Aufgabe ergibt sich für das Herstellverfahren aus den Merkmalen des Anspruchs 1 sowie hinsichtlich des Gehäuses aus den Merkmalen des Anspruchs 9. Vorteilhafte Ausgestaltungen und Weiterbildungen der Erfindung sind den jeweils zugeordneten Unteransprüchen entnehmbar.

Der Erfindung liegt die Erkenntnis zugrunde, dass durch die Verwendung von im wesentlichen rechtwinklig abgebogenen, mit ihrem zweiten Kontaktende durch eine Seitenwand des Steuergerätgehäuses hindurch geführten Steckerpins einerseits die Montagekraft beim Press-fit-Verbindungsvorgang der Leiterplatte direkt ohne Untermatrize durch das Gehäuse aufgenommen werden kann, weshalb eine der ersten Zugangsöffnung gegenüberliegende zweite Zugangsöffnung und damit ein zweiter Deckel sowie eine zweite Dichtung nicht mehr erforderlich sind.

Demnach geht die Erfindung zunächst aus von einem Verfahren zum Herstellen eines Steuergerätgehäuses mit darin angeordneten Steckerpins, die jeweils ein in das Gehäuseinnere gerichtetes erstes Kontaktende für eine Press-fit-Verbindung mit einer in das Steuergerätgehäuse einzusetzenden Leiterplatte und ein aus dem Steuergerätgehäuse nach außen gerichtetes zweites Kontaktende für den Anschluss eines elektrischen Steckverbinders oder dergleichen aufweisen. Zur Lösung der gestellten Aufgabe ist dabei vorgesehen, dass das Steuergerätgehäuse als einseitig offene Steckerwanne mit einer Zugangsöffnung zum Einsetzen der Leiterplatte ausgebildet wird, und dass die Steckerpins als im wesentlichen rechtwinklig abgebogene, im Bereich einer Seitenwand des Steuergerätgehäuses angeordnete Steckerpins derart ausgebildet werden, dass deren erstes Kontaktende zu der Zugangsöffnung hin ausgerichtet ist und deren zweites Kontaktende durch die Seitenwand hindurch nach außen ragt.

Wie bereits weiter vorne ausgeführt wurde, können die Steckerpins insbesondere über deren in einer Seitenwand des Steuergerätgehäuses verankerte zweite Kontaktenden die Montagekraft beim Press-fit-Verbindungsvorgang der Leiterplatte direkt aufnehmen, so dass eine Untermatrize zur Aufnahme dieser Montagekräfte nicht mehr erforderlich ist. Als Folge dessen kann eine der ersten Zugangsöffnung gegenüberliegende zweite Zugangsöffnung und damit ein Deckel sowie eine Dichtung zum Verschließen einer derartigen zweiten Zugangsöffnung entfallen.

Das Steuergerätgehäuse wird bevorzugt aus einem Kunststoff hergestellt, wenngleich es auch aus einem Metall hergestellt werden kann. Die jeweilige Materialauswahl richtet sich nach den auf das Steuergerätgehäuse von Außen einwirkenden Größen.

Entsprechend einer Ausgestaltung des Herstellverfahrens gemäß der Erfindung werden die Steckerpins mit dem Steuergerätgehäuse durch Umspritzen mittels eines Kunststoffs verbunden. Dieses Umspritzen der Steckerpins erfolgt vorzugsweise beim Herstellen des Steuergerätgehäuses während eines Kunststoff-Spritzgießvorgangs. Das Umspritzen von durch Spritzgießen hergestellten Kunststoffartikeln stellt ein besonders einfaches Verfahren zum Einfügen von Metall-Steckerpins in das Steuergerätgehäuse dar und gewährleistet eine besonders innige Verankerung dieser Steckerpins im Kunststoffmaterial.

Gemäß einer anderen Ausgestaltung der Erfindung ist vorgesehen, dass zunächst mehrere Steckerpins an einem gemeinsamen Steckerpinträger angeordnet werden, und dass die aus Steckerpinträger und Steckerpins gebildete Baugruppe als Ganzes durch Kunststoff-Umspritzen mit dem Steuergerätgehäuse verbunden wird. Durch das Zusammenfassen der Steckerpins zu einer Baugruppe haben die Steckerpins zueinander bereits ihre exakte gegenseitige Anordnung und Ausrichtung, die sie später im Steuergerätgehäuse haben sollen, so dass sich gegenüber einer Anordnung und Ausrichtung einzelner Steckerpins in einer Spritzgießform für das Steuergerätgehäuse eine erhebliche Fertigungsvereinfachung ergibt.

Die Steckerpins können mit dem Steckerpinträger durch einen Montagevorgang, beispielsweise durch Einpressen verbunden werden. Gemäß einem anderen, fertigungstechnisch einfacheren Verfahren ist vorgesehen, dass die Steckerpins und der Steckerpinträger in einem Kunststoff-Spritzgussvorgang miteinander verbunden werden. Nachfolgend wird der Steckerpinträger mit dem Steuergerätgehäuse durch einen zweiten Spritzgussvorgang oder durch ein Verklipsen kraft- und formschlüssig verbunden.

Um die zweiten Kontaktenden zu einer mit einem Gegenstecker verbindbaren Steckeranordnung auszubilden, ist gemäß einer weiteren Ausgestaltung der Erfindung vorgesehen, dass an eine Außenwand des Steuergerätgehäuses ein diese zweiten Kontaktenden der Steckerpins umgebendes, nach außen offenes Steckerverbindergehäuse mittels Kunststoff angespritzt wird, wie an einem Ausführungsbeispiel noch genauer dargelegt wird.

Die Verbindung zwischen den Steckerpins und dem Steuergerätgehäuse bzw. die Verbindung zwischen den Steckerpins und dem Steckerpinträger sowie die Verbindung zwischen dem Steckerpinträger und dem Steuergerätgehäuse erfolgt vorzugsweise so, dass von außen keine Medien, wie Luft, Wasser oder Öl, in dieses Steuergerätgehäuse eindringen können.

Durch das geschilderte Herstellverfahren wird demnach ein Steuergerätgehäuse mit darin angeordneten Steckerpins zur Verfügung gestellt, die jeweils ein in das Gehäuseinnere gerichtetes erstes Kontaktende für eine Press-fit-Verbindung mit einer in das Steuergerätgehäuse einzusetzenden Leiterplatte sowie ein aus dem Steuergerätgehäuse nach außen gerichtetes zweites Kontaktende für den Anschluss eines Steckverbinders oder dergleichen aufweisen. Dieses Steuergerätgehäuse ist dadurch gekennzeichnet, dass es als einseitig offene Steckerwanne mit nur einer Zugangsöffnung zum Einsetzen der Leiterplatte ausgebildet ist, wobei die Steckerpins als im wesentlichen rechtwinklig abgebogene, im Bereich einer Seitenwand des Steuergerätgehäuses angeordnete Steckerpins derart ausgebildet sind, dass deren erstes Kontaktende jeweils zur Zugangsöffnung hin ausgerichtet ist und deren zweites Kontaktende durch diese Seitenwand hindurch nach außen ragt.

Dieses Steuergerätgehäuse besteht vorzugsweise aus einem Kunststoff, jedoch kann es auch aus Metall hergestellt sein.

Durch die Zugangsöffnung wird die mit den den Steckerpins jeweils zugeordneten Aufnahmeöffnungen versehene Leiterplatte auf die Steckerpins aufgepresst (Press-fit-Verbindung), wobei die dabei auf die Steckerpins wirkenden Montagekräfte von diesen selbst insbesondere über die abgebogenen, in der Steckenrvand verankerten zweiten Kontaktenden aufgenommen werden. Zum Verschließen des Steuergerätgehäuses genügt ein einziger, mit einer entsprechenden Dichtung versehener Deckel, welcher auf die Zugangsöffnung aufgesetzt wird.

Wie bereits weiter vorne ausführlich dargelegt wurde, sind die Steckerpins vorzugsweise mit einem gemeinsamen Steckerpinträger durch Montieren oder Umspritzen mittels Kunststoff zu einer Baugruppe zusammengefasst und als Ganzes durch Umspritzen mittels Kunststoff oder durch Verklipsen mit dem Steuergerätgehäuse kraftund formschlüssig verbunden. An der den zweiten Kontaktenden der Steckerpins zugeordneten Seitenwand des Steuergerätgehäuses ist vorzugsweise ein die zweiten Kontaktenden der Baugruppe umgebendes Steckerverbindergehäuse angeordnet, in welches ein Gegenstecker eingeführt und mit diesen zweiten Kontaktenden elektrisch verbunden werden kann.

Die Verbindung zwischen den Steckerpins und dem Steuergerätgehäuse bzw. die Verbindung zwischen den Steckerpins und dem Steckerpinträger sowie die Verbindung zwischen dem Steckerpinträger und dem Steuergerätgehäuse ist vorzugsweise derartig abdichtend ausgebildet, dass von außen keine Medien, wie Luft, Wasser oder Öl, in das Steuergerätgehäuse eindringen können.

Die Erfindung lässt sich anhand eines Ausführungsbeispiels weiter erläutern. Dazu ist der Beschreibung eine Zeichnung beigefügt. In dieser zeigt
Fig. 1 ein wannenförmiges Steuergerätgehäuse mit Blick auf die Außenseite des Wannenbodens,
Fig. 2 einen Schnitt gemäß der Schnittlinie II-II in Fig. 1, und
Fig. 3 eine vergrößerte Einzelheit aus der Fig. 2 mit den elektrischen Anschlussvorrichtungen des Steuergerätgehäuses.

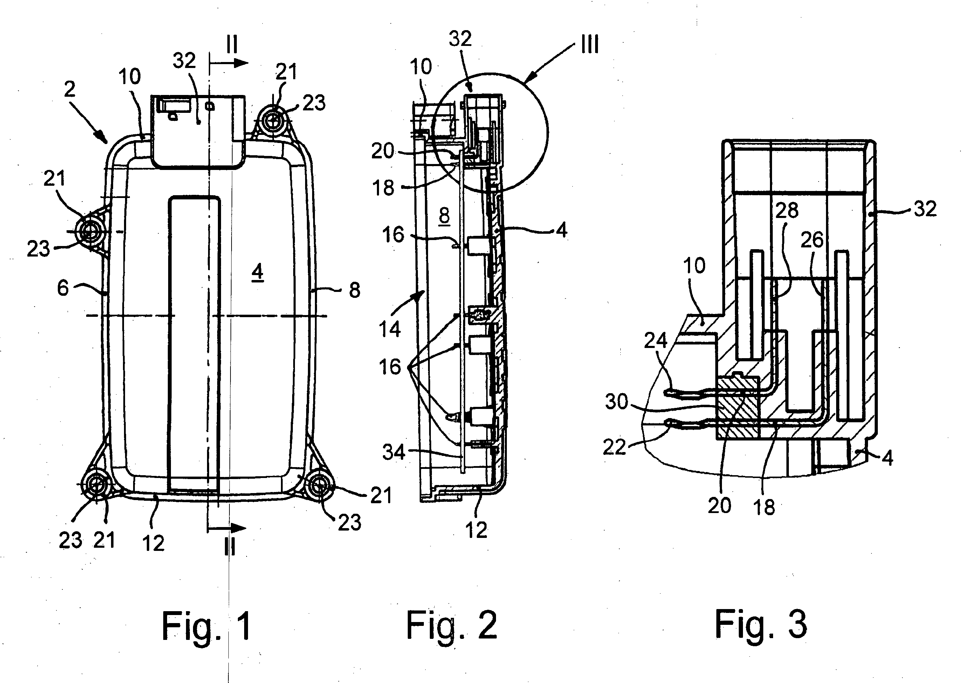

Wie insbesondere die Figuren 1 und 2 zeigen, ist das Steuergerätgehäuse 2 wannenförmig mit einem im wesentlichen rechteckigen Grundriss ausgebildet. Das Steuergerätgehäuse 2 umfasst eine Bodenwand 4, zwei mit der Bodenwand 4 verbundene und einander gegenüberliegende lange Seitenwände 6, 8 sowie zwei mit der Bodenwand 4 verbundene und einander gegenüberliegende kurze Seitenwände 10, 12.

Der Bodenwand 4 gegenüberliegend weist das Steuergerätgehäuse 2 eine Zugangsöffnung 14 auf, durch die eine Leiterplatte 34 mit zumindest einer elektronischen Schaltung in das Steuergerätgehäuse 2 eingesetzt und mit in das Steuergerätgehäuse 2 integrierte Steckerpins 18, 20 mittels Press-fit-Verbindungen verbunden werden kann. Fig. 2 zeigt eine solche Leiterplatte 34 im eingebauten Zustand, die mit den genannten Steckerpins 18, 20 und über auf der Innenseite der Bodenwand 4 angeordnete sowie unterschiedlich geformte Haltepins 16 mittels Press-fit-Verbindungen mit dem Steuergerätgehäuse 2 verbunden ist.

Im Bereich der einen ersten kurzen Seitenwand 10 sind rechtwinklig abgebogene Steckerpins 18, 20 angeordnet, deren erstes Kontaktende 22, 24 ins Innere des Steuergerätgehäuses 2 und zur Zugangsöffnung 14 hin ausgerichtet sind, und deren zweite Kontaktenden 26, 28 im wesentlichen durch die erste kurze Seitenwand 10 hindurch nach außen ragen, wie anhand der Fig. 3 noch im einzelnen erläutert wird. An den Außenseiten einzelner Seitenwände sind Ansätze 21 mit Gewindebohrungen 23 angeordnet, in die Befestigungsschrauben zum Befestigen eines die Zugangsöffnung 14 verschließenden, nicht dargestellten Deckels eingeschraubt werden können.

Fig. 3 zeigt die Einzelheit III gemäß Fig. 2 in einer vergrößerten Darstellung. In dieser Darstellung sind zwei in der der Schnittlinie II-II entsprechenden Schnittebene liegende Steckerpins 18 und 20 dargestellt. Es sei hier bemerkt, dass diese Steckerpins 18, 20 jeweils einen aus einer Reihe von senkrecht zur Zeichenebene hintereinander angeordneten Steckerpins darstellen, die zusammen demnach eine zweireihige Steckerpingruppe bilden. In jeder Reihe können beispielsweise 12 Steckerpins nebeneinander anordnet sein.

Die Steckerpins 18, 20 haben erkennbar jeweils ein ins Innere des Steuergerätgehäuses 2 und zur Zugangsöffnung 14 hin ausgerichtetes erstes Kontaktende 22, 24 sowie ein durch die erste kurze Seitenwand 10 hindurch nach außen ragendes zweites Kontaktende 26, 28. Die ersten Kontaktenden 22, 24 werden über eine Press-fit-Verbindung mit einer in das Steuergerätgehäuse 2 einzusetzenden Leiterplatte 34 verbunden, während die zweiten Kontaktenden 26, 28 einen männlichen elektrischen Steckverbinder bilden, welcher mit einem weiblichen elektrischen Gegenstecker bzw. einer weiblichen elektrischen Steckerbuchse kontaktiert wird.

Wie Fig. 3 zeigt, sind die Steckerpins 18, 20 an einem gemeinsamen Steckerpinträger 30 angeordnet, welcher seinerseits durch Umspritzen oder verklipsen mit dem Steuergerätgehäuse 2 fest verbunden ist. Die Steckerpins 18, 20 können auf eine beliebige, geeignete Weise vor dem Spritzgießen des Steuergerätgehäuses 2 mit dem Steckerpinträger 30 verbunden werden, beispielsweise durch einen Montagevorgang oder vorzugsweise durch einen vorgeschalteten Kunststoff-Spritzgießvorgang.

In Fig. 3 ist deutlich erkennbar, dass die den elektrischen Steckverbinder bildenden Kontaktenden 26, 28 der Steckerpins 18, 20 von einem nach außen offenen Steckverbindergehäuse 32 umgeben sind, welches diese Kontaktenden 26, 28 schützt und einen nicht dargestellten weiblichen elektrischen Gegenstecker bei der Herstellung der Steckverbindung mechanisch führt. Das Steckverbindergehäuse 32 wird beim Spritzgießen des Steuergerätgehäuses 2 an dieses angespritzt.

## Patentansprüche

1. Verfahren zum Herstellen eines Steuergerätgehäuses (2), mit darin angeordneten Steckerpins (18, 20), die jeweils ein in das Gehäuseinnere gerichtetes erstes Kontaktende (22, 24) für eine Press-fit-Verbindung mit einer in das Steuergerätgehäuse (2) einzusetzenden Leiterplatte (34) und ein aus dem Steuergerätgehäuse (2) nach außen gerichtetes zweites Kontaktende (26, 28) für den Anschluss eines elektrischen Steckverbinders oder dergleichen aufweisen, wobei das Steuergerätgehäuse (2) als einseitig offene Steckerwanne mit einer Zugangsöffnung (14) zum Einsetzen der Leiterplatte (34) ausgebildet wird, und die Steckerpins (18, 20) als im wesentlichen rechtwinklig abgebogene, im Bereich einer Seitenwand (10) des Steuergerätgehäuses (2) angeordnete Steckerpins (18, 20) derart ausgebildet werden, dass deren erstes Kontaktende (22, 24) zu der Zugangsöffnung (14) hin ausgerichtet ist und deren zweites Kontaktende (26, 28) durch diese Seitenwand (10) hindurch nach außen ragt, **dadurch gekennzeichnet, dass** mehrere Steckerpins (18, 20) in einem gemeinsamen Steckerpinträger (30) angeordnet werden, und dass die aus dem Steckerpinträger (30) und den Steckerpins (18, 20) gebildete Baugruppe als Ganzes durch Umspritzen mittels Kunststoff mit dem Steuergerätgehäuse (2) verbunden wird.

2. Verfahren nach Anspruch 1, **dadurch gekennzeichnet, dass** das Steuergerätgehäuse (2) aus einem Kunststoff hergestellt wird.

3. Verfahren nach Anspruch 1 oder 2, **dadurch gekennzeichnet, dass** die Steckerpins (18, 20) mit dem Steuergerätgehäuse (2) durch Umspritzen mittels Kunststoff verbunden werden.

4. Verfahren nach Anspruch 1, **dadurch gekennzeichnet, dass** die Steckerpins (18, 20) mit dem Steckerpinträger (30) durch einen Montagevorgang verbunden werden.

5. Verfahren nach Anspruch 1, **dadurch gekennzeichnet, dass** die Steckerpins (18, 20) und der Steckerpinträger (30) in einem Kunststoff-Spritzgussvorgang miteinander verbunden werden.

6. Verfahren nach einem der Ansprüche 1 bis 5, **dadurch gekennzeichnet, dass** an eine Außenwand (10) des Steuergerätgehäuses (2) ein die zweiten Kontaktenden (26, 28) der Steckerpins (18, 20) umgebendes, nach außen offenes Steckverbindergehäuse (32) angespritzt wird.

7. Verfahren nach einem der Ansprüche 1 bis 6, **dadurch gekennzeichnet, dass** die Verbindung zwischen den Steckerpins (18, 20) und dem Steuergerätgehäuse (2) oder die Verbindung zwischen den Steckerpins (18, 20) und dem Steckerpinträger (30) und die Verbindung zwischen dem Steckerpinträger (30) und dem Steuergerätgehäuse (2) dieses Steuergerätgehäuse (2) nach innen abdichtend erfolgt.

8. Steuergerätgehäuse (2) mit darin angeordneten Steckerpins (18, 20), die jeweils ein in das Gehäuseinnere gerichtetes erstes Kontaktende (22, 24) für eine Press-fit-Verbindung mit einer in das Steuergerätgehäuse (2) einsetzbaren Leiterplatte (34) und ein aus dem Steuergerätgehäuse (2) nach außen gerichtetes zweites Kontaktende (26, 28) für den Anschluss eines Steckverbinders aufweisen, wobei das Steuergerätgehäuse (2) als einseitig offene Steckerwanne mit einer Zugangsöffnung (14) zum Einsetzen der Leiterplatte (34) ausgebildet ist, wobei die Steckerpins (18, 20) als im wesentlichen rechtwinklig abgebogene, im Bereich einer Seitenwand (10) des Steuergerätgehäuses (2) angeordnete Steckerpins derart ausgebildet sind, dass deren erstes Kontaktende (22, 24) zu der Zugangsöffnung (14) hin ausgerichtet ist und deren zweites Kontaktende (26, 28) durch diese Seitenwand (10) hindurch nach außen ragt, **dadurch gekennzeichnet, dass** mehrere Steckerpins (18, 20) an einem gemeinsamen Steckerpintrager (30) angeordnet sind, und dass die aus Steckerpinträger (30) sowie Steckerpins (18, 20) gebildete Baugruppe als Ganzes durch Umspritzen mittels Kunststoff mit dem Steuergerätgehäuse (2) verbunden ist.

9. Steuergerätgehäuse nach Anspruch 8, **dadurch gekennzeichnet, dass** das Steuergerätgehäuse (2) aus einem Kunststoff hergestellt ist.

10. Steuergerätgehäuse nach Anspruch 8, **dadurch gekennzeichnet, dass** die Steckerpins (18, 20) und der Steckerpinträger (30) durch Umspritzen mittels Kunststoff miteinander verbunden sind.

11. Steuergerätgehäuse nach einem der Ansprüche 8 bis 10, **dadurch gekennzeichnet, dass** an einer Seitenwand (10) des Steuergerätgehäuses (2) ein die zweiten Kontaktenden (26, 28) der Steckerpins (18, 20) umgebendes, nach außen offenes Steckverbindergehäuse (32) angeordnet ist.

12. Steuergerätgehäuse nach einem der Ansprüche 8 bis 11, **dadurch gekennzeichnet, dass** die Verbindung zwischen den Steckerpins (18, 20) und dem Steuergerätgehäuse (2) bzw. die Verbindung zwischen den Steckerpins (18, 20) und dem Steckerpinträger (30) sowie die Verbindung zwischen dem Steckerpinträger (30) und dem Steuergerätgehäuse (2) derartig abdichtend ausgebildet ist, dass von außen keine Medien, wie Luft, Wasser oder Öl, in das Steuergerätgehäuse (2) eindringen können.

## Claims

1. Method for producing a control unit housing (2) having plug pins (18, 20) which are arranged in said control unit housing and each have a first contact end (22, 24), which is directed into the housing interior, for a press-fit connection to a printed circuit board (34) which is to be inserted into the control unit housing (2), and each have a second contact end (26, 28), which is directed outward out of the control unit housing (2), for the connection of an electrical plug connector or the like, wherein the control unit housing (2) is in the form of a plug receptacle, which is open on one side, having an access opening (14) for inserting the printed circuit board (34), and the plug pins (18, 20) are in the form of plug pins (18, 20) which are bent substantially at a right angle and are arranged in the region of a side wall (10) of the control unit housing (2), are designed in such a way that the first contact end (22, 24) of said plug pins is oriented toward the access opening (14), and the second contact end (26, 28) of said plug pins projects outward through said side wall (10), **characterized in that** a plurality of plug pins (18, 20) are arranged in a common plug pin carrier (30), and **in that** the assembly which is formed from the plug pin carrier (30) and the plug pins (18, 20) is connected, as a whole, to the control unit housing (2) by injection-molding encapsulation with plastic.

2. Method according to Claim 1, **characterized in that** the control unit housing (2) is produced from a plastic.

3. Method according to Claim 1 or 2, **characterized in that** the plug pins (18, 20) are connected to the control unit housing (2) by injection-molding encapsulation with plastic.

4. Method according to Claim 1, **characterized in that** the plug pins (18, 20) are connected to the plug pin carrier (30) by a mounting process.

5. Method according to Claim 1, **characterized in that** the plug pins (18, 20) and the plug pin carrier (30) are connected to one another in a plastic injection-molding process.

6. Method according to one of Claims 1 to 5, **characterized in that** a plug connector housing (32) which surrounds the second contact ends (26, 28) of the plug pins (18, 20) and is open toward the outside is injection-molded onto an outer wall (10) of the control unit housing (2).

7. Method according to one of Claims 1 to 6, **characterized in that** the connection between the plug pins (18, 20) and the control unit housing (2), or the connection between the plug pins (18, 20) and the plug pin carrier (30), and the connection between the plug pin carrier (30) and the control unit housing (2) are made such that said control unit housing (2) is sealed off toward the inside.

8. Control unit housing (2) having plug pins (18, 20) which are arranged in said control unit housing and each have a first contact end (22, 24), which is directed into the housing interior, for a press-fit connection to a printed circuit board (34) which is to be inserted into the control unit housing (2), and each have a second contact end (26, 28), which is directed outward out of the control unit housing (2), for the connection of a plug connector, wherein the control unit housing (2) is in the form of a plug receptacle, which is open on one side, having an access opening (14) for inserting the printed circuit board (34), wherein the plug pins (18, 20) are in the form of plug pins which are bent substantially at a right angle and are arranged in the region of a side wall (10) of the control unit housing (2), are designed in such a way that the first contact end (22, 24) of said plug pins is oriented toward the access opening (14), and the second contact end (26, 28) of said plug pins projects outward through said side wall (10), **characterized in that** a plurality of plug pins (18, 20) are arranged on a common plug pin carrier (30), and **in that** the assembly which is formed from the plug pin carrier (30) and also plug pins (18, 20) is connected, as a whole, to the control unit housing by injection-molding encapsulation with plastic.

9. Control unit housing according to Claim 8, **characterized in that** the control unit housing (2) is produced from a plastic.

10. Control unit housing according to Claim 8, **characterized in that** the plug pins (18, 20) and the plug pin carrier (30) are connected to one another by injection-molding encapsulation with plastic.

11. Control unit housing according to one of Claims 8 to 10, **characterized in that** a plug connector housing (32) which surrounds the second contact ends (26, 28) of the plug pins (18, 20) and is open toward the outside is arranged on a side wall (10) of the control unit housing (2).

12. Control unit housing according to one of Claims 8 to 11, **characterized in that** the connection between the plug pins (18, 20) and the control unit housing (2), or the connection between the plug pins (18, 20) and the plug pin carrier (30), and also the connection between the plug pin carrier (30) and the control unit housing (2) is designed in a sealed off manner in such a way that no media, such as air, water or oil, can enter the control unit housing (2) from the outside.

## Revendications

1. Procédé de fabrication d'un boîtier de contrôleur (2) dans lequel sont disposées des broches mâles (18, 20) qui possèdent respectivement une première extrémité de contact (22, 24) dirigée vers l'intérieur du boîtier pour une liaison par sertissage avec un circuit imprimé (34) à introduire dans le boîtier de contrôleur (2) et une deuxième extrémité de contact (26, 28) dirigée vers l'extérieur depuis le boîtier de contrôleur (2) pour le raccordement d'un connecteur électrique ou similaire, le boîtier de contrôleur (2) étant réalisé sous la forme d'un bac de connexion ouvert d'un côté muni d'une ouverture d'accès (14) servant à l'introduction du circuit imprimé (34), et les broches mâles (18, 20) étant réalisées sous la forme de broches mâles (18, 20) sensiblement coudées à angle droit disposées dans la zone d'une paroi latérale (10) du boîtier de contrôleur (2) de telle sorte que leur première extrémité de contact (22, 24) est dirigée vers l'ouverture d'accès (14) et que leur deuxième extrémité de contact (26, 28) fait saillie vers l'extérieur à travers cette paroi latérale (10), **caractérisé en ce que** plusieurs broches mâles (18, 20) sont disposées dans un porte-broches mâles (30) commun et **en ce que** le module formé par le porte-broches mâles (30) et les broches mâles (18, 20) est relié au boîtier de contrôleur (2) en tant qu'ensemble par surmoulage au moyen de matière plastique.

2. Procédé selon la revendication 1, **caractérisé en ce que** le boîtier de contrôleur (2) est fabriqué en une matière plastique.

3. Procédé selon la revendication 1 ou 2, **caractérisé en ce que** les broches mâles (18, 20) sont reliées au boîtier de contrôleur (2) par surmoulage au moyen de matière plastique.

4. Procédé selon la revendication 1, **caractérisé en ce que** les broches mâles (18, 20) sont reliées au porte-broches mâles (30) par une opération de montage.

5. Procédé selon la revendication 1, **caractérisé en ce que** les broches mâles (18, 20) et le porte-broches mâles (30) sont reliés ensemble par une opération de moulage par injection de matière plastique.

6. Procédé selon l'une des revendications 1 à 5, **caractérisé en ce que** sur une paroi extérieure (10) du boîtier de contrôleur (2) est moulé par injection un boîtier de connecteur (32) ouvert vers l'extérieur qui entoure les deuxièmes extrémités de contact (26, 28) des broches mâles (18, 20).

7. Procédé selon l'une des revendications 1 à 6, **caractérisé en ce que** la liaison entre les broches mâles (18, 20) et le boîtier de contrôleur (2) ou la liaison entre les broches mâles (18, 20) et le porte-broches mâles (30) et la liaison entre le porte-broches mâles (30) et le boîtier de contrôleur (2) s'effectuent en réalisant l'étanchéité de ce boîtier de contrôleur (2) vers l'intérieur.

8. Boîtier de contrôleur (2) dans lequel sont disposées des broches mâles (18, 20) qui possèdent respectivement une première extrémité de contact (22, 24) dirigée vers l'intérieur du boîtier pour une liaison par sertissage avec un circuit imprimé (34) pouvant être introduit dans le boîtier de contrôleur (2) et une deuxième extrémité de contact (26, 28) dirigée vers l'extérieur depuis le boîtier de contrôleur (2) pour le raccordement d'un connecteur, le boîtier de contrôleur (2) étant réalisé sous la forme d'un bac de connexion ouvert d'un côté muni d'une ouverture d'accès (14) servant à l'introduction du circuit imprimé (34), les broches mâles (18, 20) étant réalisées sous la forme de broches mâles sensiblement coudées à angle droit disposées dans la zone d'une paroi latérale (10) du boîtier de contrôleur (2) de telle sorte que leur première extrémité de contact (22, 24) est dirigée vers l'ouverture d'accès (14) et que leur deuxième extrémité de contact (26, 28) fait saillie vers l'extérieur à travers cette paroi latérale (10), **caractérisé en ce que** plusieurs broches mâles (18, 20) sont disposées sur un porte-broches mâles (30) commun et **en ce que** le module formé par le porte-broches mâles (30) et les broches mâles (18, 20) est relié au boîtier de contrôleur (2) en tant qu'ensemble par surmoulage au moyen de matière plastique.

9. Boîtier de contrôleur selon la revendication 8, **caractérisé en ce que** le boîtier de contrôleur (2) est fabriqué en une matière plastique.

10. Boîtier de contrôleur selon la revendication 8, **caractérisé en ce que** les broches mâles (18, 20) et le porte-broches mâles (30) sont reliés ensemble par surmoulage au moyen de matière plastique.

11. Boîtier de contrôleur selon l'une des revendications 8 à 10, **caractérisé en ce qu'**un boîtier de connecteur (32) ouvert vers l'extérieur qui entoure les deuxièmes extrémités de contact (26, 28) des broches mâles (18, 20) est disposé sur une paroi latérale (10) du boîtier de contrôleur (2).

12. Boîtier de contrôleur selon l'une des revendications 8 à 11, **caractérisé en ce que** la liaison entre les broches mâles (18, 20) et le boîtier de contrôleur (2) ou la liaison entre les broches mâles (18, 20) et le porte-broches mâles (30) ainsi que la liaison entre le porte-broches mâles (30) et le boîtier de contrôleur (2) sont réalisées de manière étanche de telle sorte qu'aucun fluide tel que l'air, l'eau ou l'huile ne peut pénétrer dans le boîtier de contrôleur (2) depuis l'extérieur.
